# EUROPEAN PATENT APPLICATION

(11) **EP 4 697 383 A1**
(43) Date of publication of application: **18.02.2026**
(21) Application number: 24788555.1
(22) Date of filing: 26.03.2024
(51) Int. Cl.: H01L 27/146, H04N 25/76

(54) **SOLID-STATE IMAGING ELEMENT, MANUFACTURING METHOD, AND ELECTRONIC DEVICE**

(30) Priority: 10.04.2023 JP 2023063183
(71) Applicant: Sony Semiconductor Solutions Corporation, Atsugi-shi, Kanagawa 243-0014 (JP)
(72) Inventor: KITANO, Yoshiaki, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/011879
(87) International publication number: WO 2024/214527

(57) **Abstract**

The present disclosure relates to a solid-state imaging element, a manufacturing method, and an electronic apparatus that can further improve image quality. The solid-state imaging element includes a color filter provided, for each of a plurality of pixels, on a back surface side of a semiconductor substrate with an insulating layer interposed between the color filter and the semiconductor substrate, the back surface side of the semiconductor substrate being illuminated with light, a waveguide disposed between adjacent ones of the color filters, the waveguide being formed of a low-refractive-index material having a refractive index lower than a refractive index of the color filters, and a metal layer disposed on a semiconductor substrate side of the waveguide and in the insulating layer on the semiconductor substrate side of a semiconductor-substrate-side surface of the color filters, the metal layer being configured in a shape in which a width of a lower portion closer to the semiconductor substrate is narrower than a width of an upper portion closer to the waveguide. The present technology can be applied to, for example, a back-illuminated CMOS image sensor.

## Description

### Technical Field

The present disclosure relates to a solid-state imaging element, a manufacturing method, and an electronic apparatus, and particularly relates to a solid-state imaging element, a manufacturing method, and an electronic apparatus that can further improve image quality.

### Background Art

In the related art, in solid-state imaging elements such as complementary metal oxide semiconductor (CMOS) image sensors, image quality decreases when color mixing occurs as a result of light transmitted through a color filter of a given pixel being incident on a photodiode of another adjacent pixel.

Therefore, PTL 1 proposes a solid-state imaging element having a structure in which a barrier metal having a narrower width than a low-refractive-index wall portion provided between color filters is provided below the low-refractive-index wall portion, thereby suppressing the occurrence of color mixing between pixels.

### Citation List

### Patent Literature

[PTL 1] JP 2023-006303 A

### Summary

### Technical Problem

There is a demand to improve image quality over the related art by, for example, suppressing a decrease in the sensitivity of pixels while suppressing the occurrence of color mixing between the pixels more than the structure disclosed in PTL 1 described above.

The present disclosure has been made in view of such circumstances, and is intended to further improve image quality.

### Solution to Problem

A solid-state imaging element according to an aspect of the present disclosure includes a color filter provided, for each of a plurality of pixels, on a back surface side of a semiconductor substrate with an insulating layer interposed between the color filter and the semiconductor substrate, the back surface side of the semiconductor substrate being illuminated with light, a waveguide disposed between adjacent ones of the color filters, the waveguide being formed of a low-refractive-index material having a refractive index lower than a refractive index of the color filters, and a metal layer disposed on a semiconductor substrate side of the waveguide and in the insulating layer on the semiconductor substrate side of a semiconductor-substrate-side surface of the color filters, the metal layer being configured in a shape in which a width of a lower portion closer to the semiconductor substrate is narrower than a width of an upper portion closer to the waveguide.

A method of manufacturing a solid-state imaging element according to an aspect of the present disclosure includes providing, for each of a plurality of pixels, a color filter on a back surface side of a semiconductor substrate with an insulating layer interposed between the color filter and the semiconductor substrate, the back surface side of the semiconductor substrate being illuminated with light, providing a waveguide disposed between adjacent ones of the color filters, the waveguide being formed of a low-refractive-index material having a refractive index lower than a refractive index of the color filters, and providing a metal layer disposed on a semiconductor substrate side of the waveguide and in the insulating layer on the semiconductor substrate side of a semiconductor-substrate-side surface of the color filters, the metal layer being configured in a shape in which a width of a lower portion closer to the semiconductor substrate is narrower than a width of an upper portion closer to the waveguide.

An electronic apparatus according to an aspect of the present disclosure includes a solid-state imaging element including a color filter provided, for each of a plurality of pixels, on a back surface side of a semiconductor substrate with an insulating layer interposed between the color filter and the semiconductor substrate, the back surface side of the semiconductor substrate being illuminated with light, a waveguide disposed between adjacent ones of the color filters, the waveguide being formed of a low-refractive-index material having a refractive index lower than a refractive index of the color filters, and a metal layer disposed on a semiconductor substrate side of the waveguide and in the insulating layer on the semiconductor substrate side of a semiconductor-substrate-side surface of the color filters, the metal layer being configured in a shape in which a width of a lower portion closer to the semiconductor substrate is narrower than a width of an upper portion closer to the waveguide.

In an aspect of the present disclosure, a color filter is provided, for each of a plurality of pixels, on a back surface side of a semiconductor substrate with an insulating layer interposed between the color filter and the semiconductor substrate, the back surface side of the semiconductor substrate being illuminated with light. A waveguide is disposed between adjacent ones of the color filters and is formed of a low-refractive-index material having a refractive index lower than a refractive index of the color filters. A metal layer is disposed on a semiconductor substrate side of the waveguide and in the insulating layer on the semiconductor substrate side of a semiconductor-substrate-side surface of the color filters, the metal layer being configured in a shape in which a width of a lower portion closer to the semiconductor substrate is narrower than a width of an upper portion closer to the waveguide.

### Brief Description of Drawings

[Fig. 1]

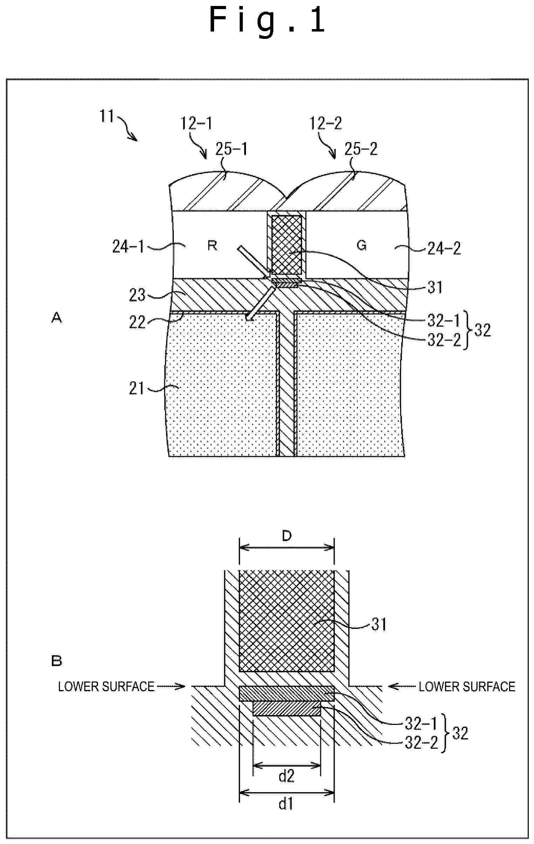

   Fig. 1 is a cross-sectional view illustrating a configuration example of a first embodiment of an imaging element to which the present technology is applied.
[Fig. 2]

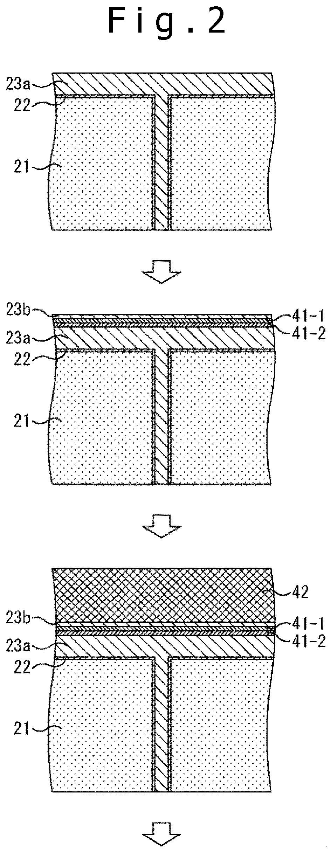

   Fig. 2 is a diagram for describing a method of manufacturing the imaging element in Fig. 1.
[Fig. 3]

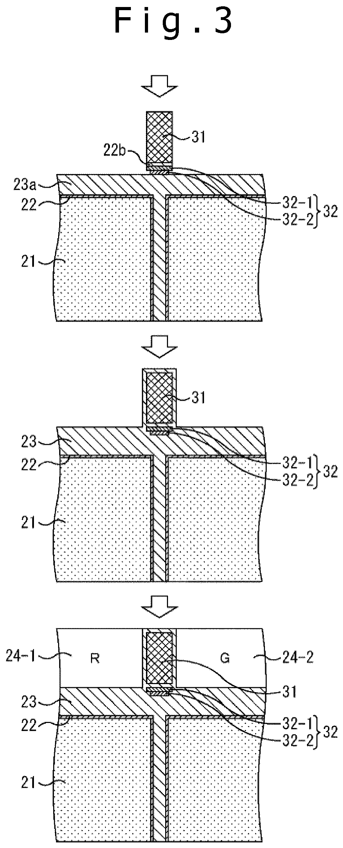

   Fig. 3 is a diagram for describing the method of manufacturing the imaging element in Fig. 1.
[Fig. 4]

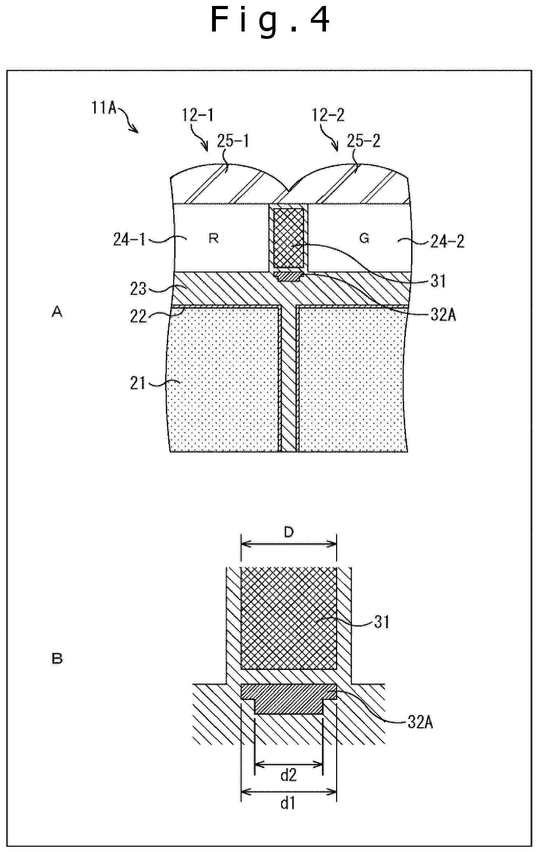

   Fig. 4 is a cross-sectional view illustrating a configuration example of a second embodiment of the imaging element.
[Fig. 5]

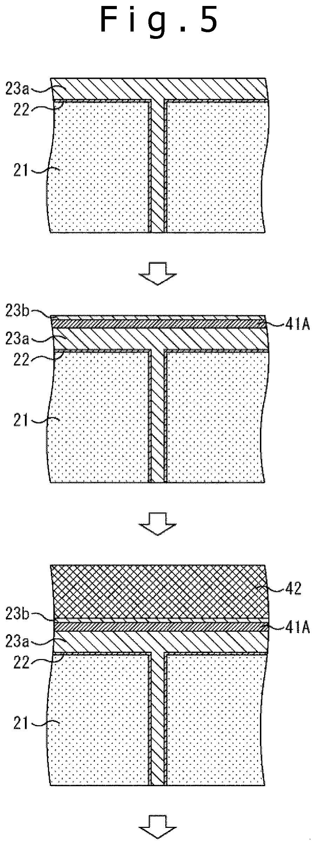

   Fig. 5 is a diagram for describing a method of manufacturing the imaging element in Fig. 4.
[Fig. 6]

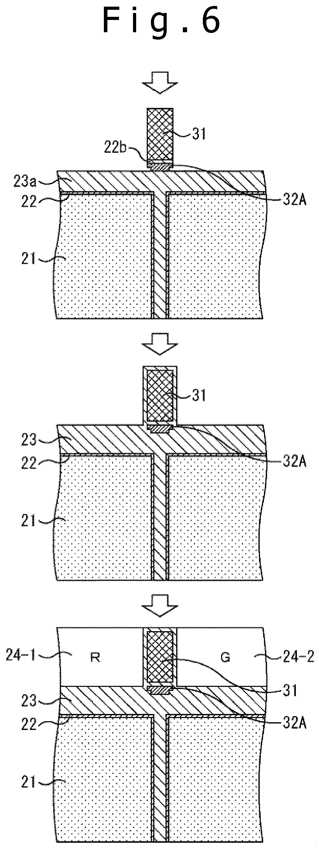

   Fig. 6 is a diagram for describing the method of manufacturing the imaging element in Fig. 4.
[Fig. 7]

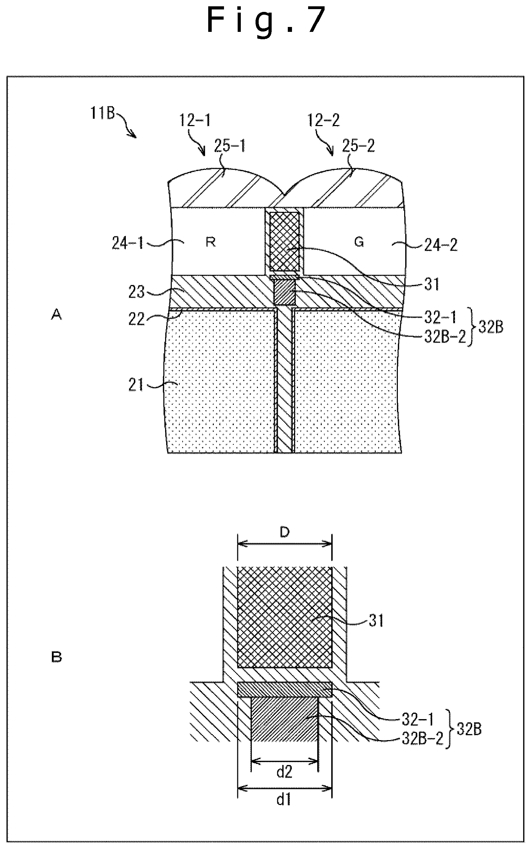

   Fig. 7 is a cross-sectional view illustrating a configuration example of a third embodiment of the imaging element.
[Fig. 8]

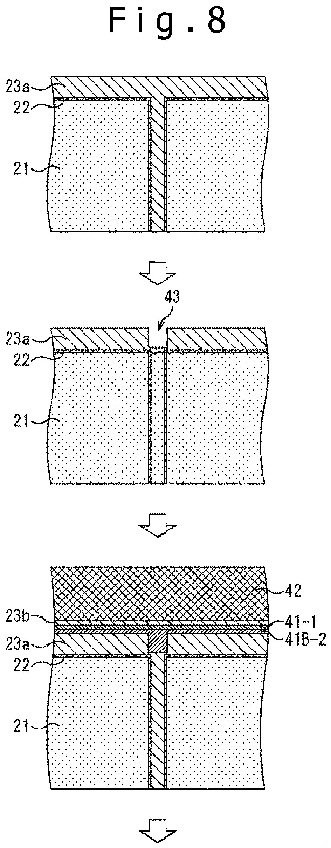

   Fig. 8 is a diagram for describing a method of manufacturing the imaging element in Fig. 7.
[Fig. 9]

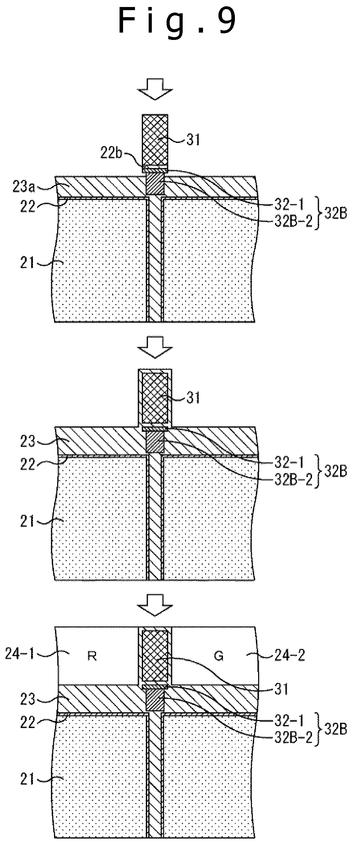

   Fig. 9 is a diagram for describing the method of manufacturing the imaging element in Fig. 7.
[Fig. 10]

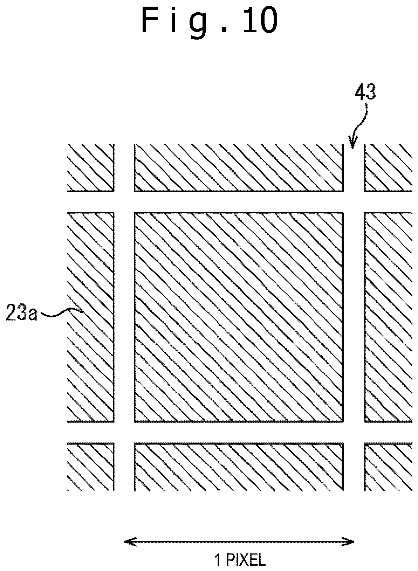

   Fig. 10 is a plan view of a groove portion illustrated in Fig. 8.
[Fig. 11]

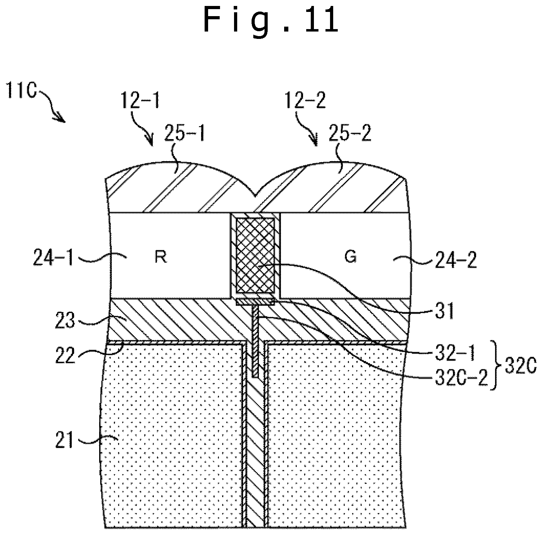

   Fig. 11 is a cross-sectional view illustrating a first modification example of the imaging element.
[Fig. 12]

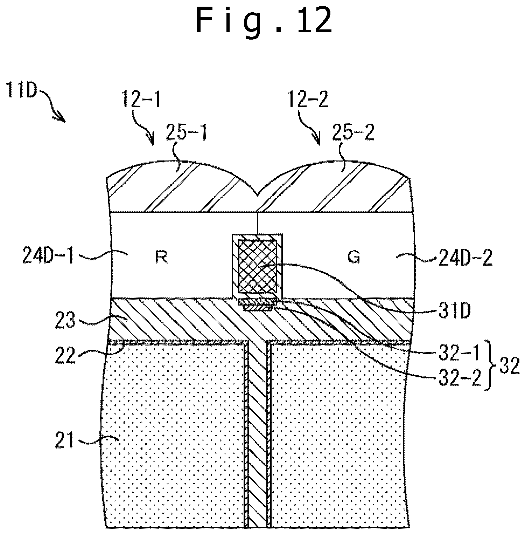

   Fig. 12 is a cross-sectional view illustrating a second modification example of the imaging element.
[Fig. 13]

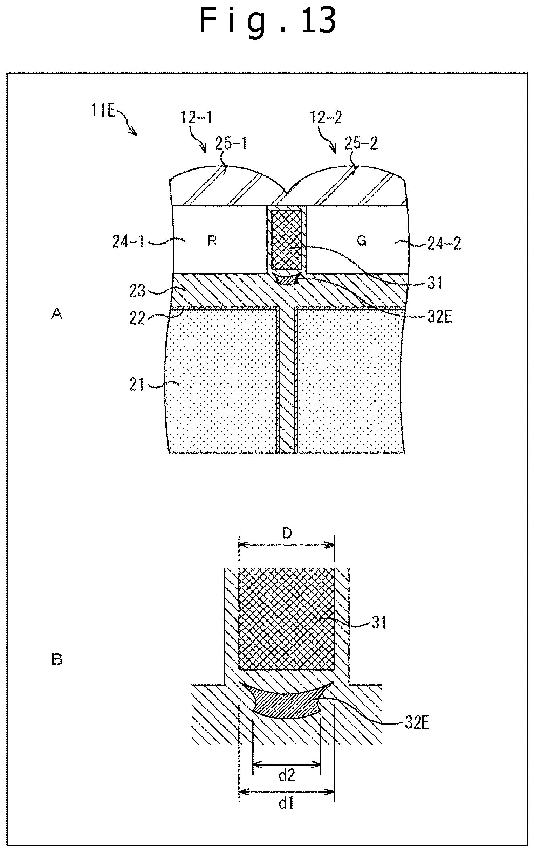

   Fig. 13 is a cross-sectional view illustrating a third modification example of the imaging element.
[Fig. 14]

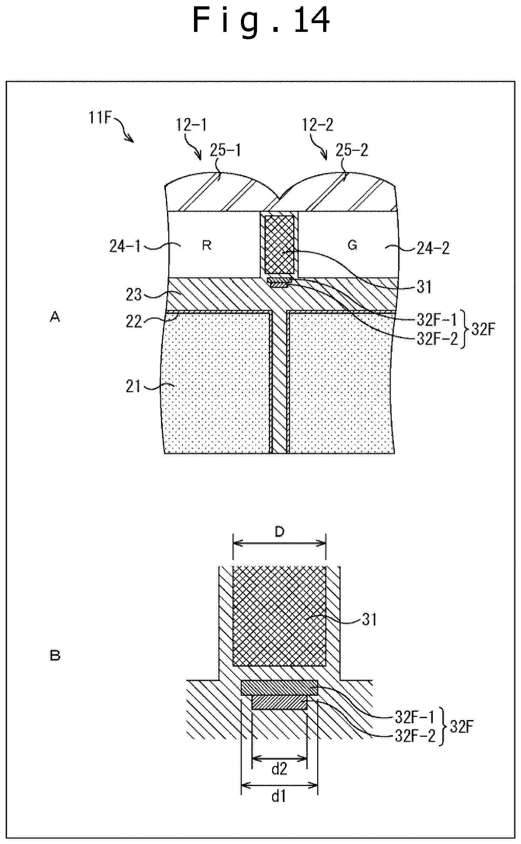

   Fig. 14 is a cross-sectional view illustrating a fourth modification example of the imaging element.
[Fig. 15]

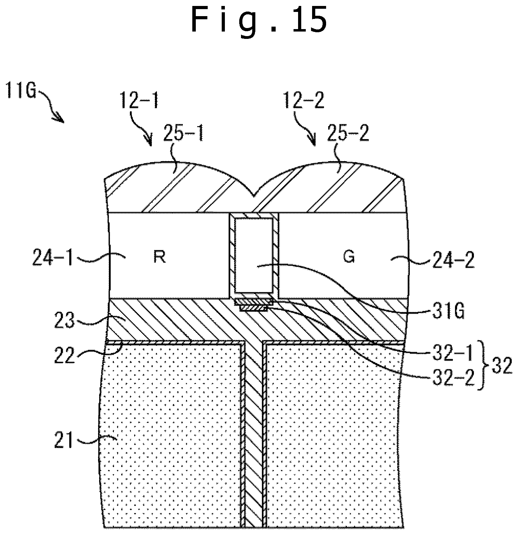

   Fig. 15 is a cross-sectional view illustrating a fifth modification example of the imaging element.
[Fig. 16]

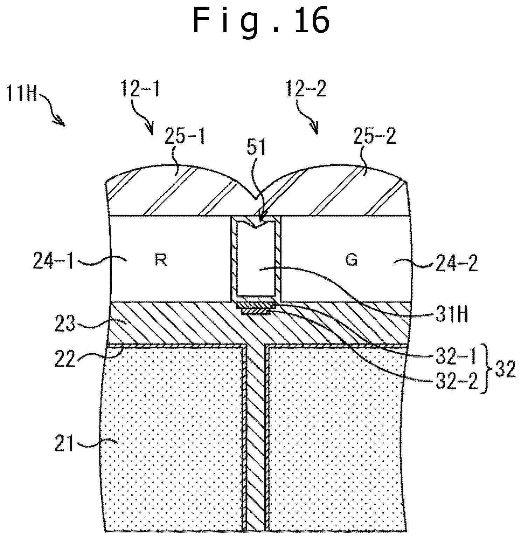

   Fig. 16 is a cross-sectional view illustrating a sixth modification example of the imaging element.
[Fig. 17]

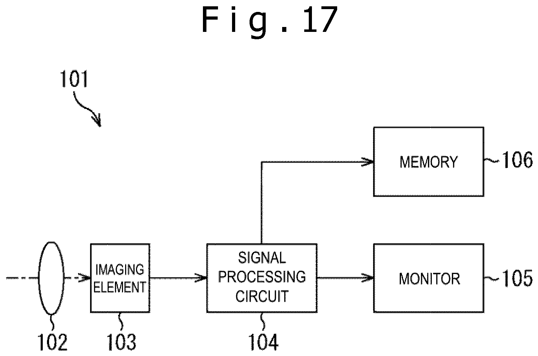

   Fig. 17 is a block diagram illustrating a configuration example of an imaging device.
[Fig. 18]

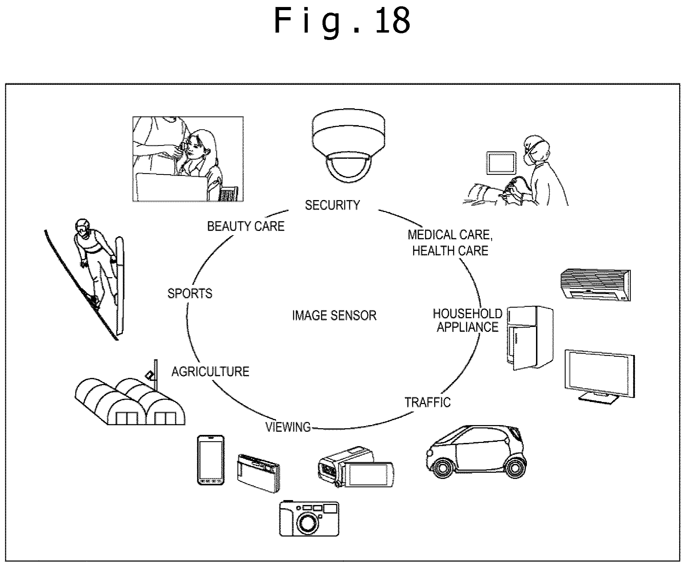

   Fig. 18 is a diagram illustrating usage examples of an image sensor.

### Description of Embodiments

Hereinafter, specific embodiments to which the present technology is applied will be described in detail with reference to the drawings.

### First Configuration Example of Imaging Element

Fig. 1 is a cross-sectional view illustrating a configuration example of a first embodiment of an imaging element to which the present technology is applied.

A in Fig. 1 illustrates a cross-sectional configuration example of two pixels 12-1 and 12-2 adjacent to each other in an imaging element 11, and B in Fig. 1 illustrates, in an enlarged view, the structure of a metal layer 32 provided between the two pixels 12-1 and 12-2 and the vicinity of the metal layer 32.

As illustrated in A in Fig. 1, the imaging element 11 is configured by layering a semiconductor substrate 21, a high-dielectric-constant film 22, and an insulating layer 23, and by layering color filters 24-1 and 24-2 and on-chip lenses 25-1 and 25-2 for the pixels 12-1 and 12-2, respectively. Note that the pixels 12-1 and 12-2, the color filters 24-1 and 24-2, and the on-chip lenses 25-1 and 25-2 are simply referred to as pixels 12, color filters 24, and on-chip lenses 25, respectively, when no distinction is necessary therebetween. Further, the imaging element 11 is configured by providing a waveguide 31 and the metal layer 32 between the pixels 12. For example, the imaging element 11 is a back-illuminated CMOS image sensor in which a back surface of the semiconductor substrate 21 is illuminated with light.

The semiconductor substrate 21 is formed of, for example, a single-crystal silicon wafer, and is provided with a photodiode for each pixel 12. In addition, in the semiconductor substrate 21, a trench is formed so as to penetrate between adjacent ones of the pixels 12, the high-dielectric-constant film 22 is deposited on side surfaces of the trench, and an element isolation structure in which a part of the insulating layer 23 is embedded is provided inside the trench. That is, the imaging element 11 is configured to be provided with the element isolation structure, which provides electrical and optical isolation in the semiconductor substrate 21 between the plurality of pixels 12.

The high-dielectric-constant film 22 is formed of an insulator such as, for example, aluminum oxide or hafnium oxide, having a higher relative dielectric constant than silicon dioxide. The insulating layer 23 is formed of an insulator such as silicon dioxide, for example.

The color filters 24 transmit light to be received by the respective pixels 12. In the example illustrated in the drawing, the color filter 24-1 transmits red light, and the color filter 24-2 transmits green light. The on-chip lenses 25 collect light for the corresponding pixels 12.

The waveguide 31 is disposed between adjacent ones of the color filters 24. The waveguide 31 is formed of a low-refractive-index material having a refractive index lower than a refractive index of the color filters 24 (for example, n = 1.0 to 1.5). Due to the difference in refractive index therebetween, light traveling from a side surface of the color filter 24 of a given pixel 12 toward an adjacent pixel 12 can be totally reflected and guided into the given pixel 12. In addition, in a cross-sectional view as illustrated in the drawing, upper and lower surfaces and both side surfaces of the waveguide 31 are surrounded by a thin film of the insulating layer 23 in order to protect the waveguide 31. Examples of the low-refractive-index material constituting the waveguide 31 include an inorganic film of SiN, SiO2, SiON, or the like and a resin-based material (organic film) such as a styrene-based resin, an acrylic-based resin, a styrene-acrylic copolymer-based resin, or a siloxane-based resin.

The metal layer 32 is disposed below the waveguide 31 and closer to the semiconductor substrate 21 than the color filters 24. In addition, in the imaging element 11, the metal layer 32 has a two-layer structure of a metal layer 32-1 and a metal layer 32-2. The metal layer 32-1 and the metal layer 32-2 are formed of different types of metals. For example, metals having light shielding properties such as Ti, TiN, and W are used in combination.

As illustrated in B in Fig. 1, the metal layer 32 is configured in a shape in which a width d1 of the metal layer 32-1 is a width equal to or less than a width D of the waveguide 31 (a width substantially the same as the width D or narrower than the width D), and configured in a shape in which a width d2 of the metal layer 32-2 is narrower than the width d1 of the metal layer 32-1. Further, as illustrated in the drawing, the metal layer 32-1 and the metal layer 32-2 are disposed in the insulating layer 23, located on the semiconductor substrate 21 side of the lower surfaces of the color filters 24.

By providing the metal layer 32 having such a configuration below the waveguide 31, light incident in an oblique direction as illustrated by a hollow arrow, for example, can be reflected by the metal layer 32, and the occurrence of color mixing between the pixels 12 can be suppressed. Further, with the shape having a narrower width on the semiconductor substrate 21 side, the metal layer 32 can improve quantum efficiency Qe by reducing light absorption and suppress a decrease in the sensitivity of the pixels 12.

In this manner, the imaging element 11 suppresses the occurrence of color mixing between the pixels 12 and suppresses a decrease in the sensitivity of the pixels 12, thereby enabling further improvement in image quality.

A method of manufacturing the imaging element 11 will be described with reference to Figs. 2 and 3.

In a first step, as illustrated in the first row in Fig. 2, the high-dielectric-constant film 22 is deposited on the back surface of the semiconductor substrate 21, and the high-dielectric-constant film 22 is deposited on the side surfaces of the trench formed between the pixels 12, in the semiconductor substrate 21. Further, an insulator 23a, which is to serve as a part of the insulating layer 23, is layered on the back surface of the semiconductor substrate 21 and embedded inside the trench of the semiconductor substrate 21, with the high-dielectric-constant film 22 interposed between the insulator 23a and the semiconductor substrate 21.

In a second step, as illustrated in the second row in Fig. 2, a metal film 41-2, which is to serve as the metal layer 32-2, a metal film 41-1, which is to serve as the metal layer 32-1, and an insulating film 23b, which is to serve as a part of the insulating layer 23, are deposited on the insulator 23a.

In a third step, as illustrated in the third row in Fig. 2, a waveguide member 42, which is to serve as the waveguide 31, is layered on the insulating film 23b.

In a fourth step, the waveguide member 42, the insulating film 23b, the metal film 41-1, and the metal film 41-2 are processed by, for example, wet etching. As a result, the waveguide 31 and the metal layer 32 are formed between the pixels 12 as illustrated in the first row in Fig. 3. At this time, by optimizing the type, ratio, and rate of a chemical solution for the wet etching, the metal layer 32 is processed such that the width d2 of the metal layer 32-2 is narrower than the width d1 of the metal layer 32-1 as illustrated in B in Fig. 1.

In a fifth step, an insulating film is deposited so as to be layered on the insulator 23a, so as to surround both side surfaces and an upper surface of the waveguide 31, and so as to be connected to the insulating film 23b, thereby forming the insulating layer 23 that protects the waveguide 31 as illustrated in the second row in Fig. 3. Note that the insulating layer 23 configured by depositing the insulating films in a plurality of steps may be formed of insulating films deposited using different deposition methods in the respective steps.

In a sixth step, as illustrated in the third row in Fig. 3, the color filter 24-1 and the color filter 24-2 are formed such that the waveguide 31 is provided therebetween. Thereafter, the on-chip lenses 25 are layered, and thus the imaging element 11 as illustrated in Fig. 1 is manufactured.

By the manufacturing method described above, it is possible to manufacture the imaging element 11 capable of suppressing the occurrence of color mixing between the pixels 12 and suppressing a decrease in the sensitivity of the pixels 12.

Note that, in the imaging element 11, the trench formed between the pixels 12, in the semiconductor substrate 21, may be formed by digging from either the back surface side or the front surface side of the semiconductor substrate 21, and may be formed so as to penetrate the semiconductor substrate 21.

### Second Configuration Example of Imaging Element

Fig. 4 is a cross-sectional view illustrating a configuration example of a second embodiment of the imaging element to which the present technology is applied. In an imaging element 11A illustrated in Fig. 4, components common to those of the imaging element 11 in Fig. 1 are denoted by the same reference signs, and detailed description thereof will be omitted.

As illustrated in Fig. 4, the semiconductor substrate 21, the high-dielectric-constant film 22, the insulating layer 23, the color filters 24, the on-chip lenses 25, and the waveguide 31 of the imaging element 11A are configured in the same manner as those of the imaging element 11 in Fig. 1. On the other hand, a metal layer 32A of the imaging element 11A has a configuration different from that of the metal layer 32 of the imaging element 11 in Fig. 1.

That is, the metal layer 32 in Fig. 1 has a two-layer structure formed of different types of metals, whereas the metal layer 32A has a single-layer structure formed of a single type of metal such that an upper portion and a lower portion have different widths. That is, as illustrated in B in Fig. 4, the metal layer 32A is formed in a T-shape in a cross-sectional view, with a part closer to the waveguide 31, which serves as the upper portion, being formed to have the wide width d1 (equal to or less than the width D of the waveguide 31) and a part closer to the semiconductor substrate 21, which serves as the lower portion, being formed to have the narrow width d2.

In a manner similar to the imaging element 11 in Fig. 1, the imaging element 11A having such a configuration suppresses the occurrence of color mixing between the pixels 12 and suppresses a decrease in the sensitivity of the pixels 12, thereby enabling further improvement in image quality.

A method of manufacturing the imaging element 11A will be described with reference to Figs. 5 and 6.

In an eleventh step, as illustrated in the first row in Fig. 5, the high-dielectric-constant film 22 is deposited on a back surface of the semiconductor substrate 21, and the high-dielectric-constant film 22 is deposited on side surfaces of a trench formed between the pixels 12, in the semiconductor substrate 21. Further, the insulator 23a, which is to serve as a part of the insulating layer 23 is layered on the back surface of the semiconductor substrate 21 and embedded inside the trench of the semiconductor substrate 21, with the high-dielectric-constant film 22 interposed between the insulator 23a and the semiconductor substrate 21.

In a twelfth step, as illustrated in the second row in Fig. 5, a metal film 41A, which is to serve as the metal layer 32A, and the insulating film 23b, which is to serve as a part of the insulating layer 23, are deposited on the insulator 23a.

In a thirteenth step, as illustrated in the third row in Fig. 5, the waveguide member 42, which is to serve as the waveguide 31, is layered on the insulating film 23b.

In a fourteenth step, the waveguide member 42, the insulating film 23b, and the metal film 41A are processed by, for example, wet etching. As a result, the waveguide 31 and the metal layer 32A are formed between the pixels 12 as illustrated in the first row in Fig. 6. At this time, by optimizing the type, ratio, and rate of a chemical solution for the wet etching, the metal layer 32A is processed such that the width d2 of the lower portion of the metal layer 32A is narrower than the width d1 of the upper portion of the metal layer 32A as illustrated in B in Fig. 4.

In a fifteenth step, an insulating film is deposited so as to be layered on the insulator 23a and to surround both side surfaces and an upper surface of the waveguide 31 and connect to the insulating film 23b, thereby forming the insulating layer 23 that protects the waveguide 31 as illustrated in the second row in Fig. 6.

In a sixteenth step, as illustrated in the third row in Fig. 6, the color filter 24-1 and the color filter 24-2 are formed such that the waveguide 31 is provided therebetween. Thereafter, the on-chip lenses 25 are layered, and thus the imaging element 11 as illustrated in Fig. 1 is manufactured.

By the manufacturing method described above, it is possible to manufacture the imaging element 11A capable of suppressing the occurrence of color mixing between the pixels 12 and suppressing a decrease in the sensitivity of the pixels 12.

### Third Configuration Example of Imaging Element

Fig. 7 is a cross-sectional view illustrating a configuration example of a third embodiment of the imaging element to which the present technology is applied. In an imaging element 11B illustrated in Fig. 7, components common to those of the imaging element 11 in Fig. 1 are denoted by the same reference signs, and detailed description thereof will be omitted.

As illustrated in Fig. 7, the semiconductor substrate 21, the high-dielectric-constant film 22, the insulating layer 23, the color filters 24, the on-chip lenses 25, and the waveguide 31 of the imaging element 11B are configured in the same manner as those of the imaging element 11 in Fig. 1. On the other hand, a metal layer 32B of the imaging element 11B has a configuration different from the configuration of the metal layer 32 of the imaging element 11 in Fig. 1.

That is, the metal layer 32-1 and the metal layer 32-2 of the metal layer 32 in Fig. 1 have substantially the same thickness, whereas the metal layer 32B has a structure in which a metal layer 32B-2 is formed to have a thickness (length in a depth direction toward the semiconductor substrate 21) larger than the metal layer 32-1. For example, the metal layer 32B-2 is formed to a depth reaching the vicinity of the semiconductor substrate 21.

The imaging element 11B having such a configuration can suppress the occurrence of color mixing more than the imaging element 11 in Fig. 1 and can further improve image quality.

A method of manufacturing the imaging element 11B will be described with reference to Figs. 8 to 10.

In a thirty-first step, as illustrated in the first row in Fig. 8, the high-dielectric-constant film 22 is deposited on a back surface of the semiconductor substrate 21, and the high-dielectric-constant film 22 is deposited on side surfaces of a trench formed between the pixels 12, in the semiconductor substrate 21. Further, the insulator 23a, which is to serve as a part of the insulating layer 23, is layered on the back surface of the semiconductor substrate 21 and embedded inside the trench of the semiconductor substrate 21, with the high-dielectric-constant film 22 interposed between the insulator 23a and the semiconductor substrate 21.

In a thirty-second step, as illustrated in the second row in Fig. 8, processing of digging groove portions 43 in the insulator 23a between the pixels 12 is performed. For example, the groove portions 43 are processed to a depth in the vicinity of the semiconductor substrate 21 according to the thickness of the metal layer 32B-2. As illustrated in a planar manner in Fig. 10, the groove portions 43 are formed in the insulator 23a at intervals corresponding to the widths of the pixels 12.

In a thirty-third step, as illustrated in the third row in Fig. 8, a metal film 41B-2, which is to serve as the metal layer 32B-2, is deposited on the insulator 23a, and at this time, the metal film 41B-2 is embedded in the groove portions 43. Further, the metal film 41-1, which is to serve as the metal layer 32-1, and the insulating film 23b, which is to serve as a part of the insulating layer 23, are deposited, and the waveguide member 42, which is to serve as the waveguide 31, is layered.

In a thirty-fourth step, the waveguide member 42, the insulating film 23b, the metal film 41-1, and the metal film 41B-2 are processed by, for example, wet etching. As a result, the waveguide 31 and the metal layer 32B are formed between the pixels 12 as illustrated in the first row in Fig. 9. At this time, by optimizing the type, ratio, and rate of a chemical solution for the wet etching, the metal layer 32B is processed such that the width d2 of the metal layer 32B-2 is narrower than the width d1 of the metal layer 32-1 as illustrated in B in Fig. 7.

In a thirty-fifth step, an insulating film is deposited so as to be layered on the insulator 23a and to surround both side surfaces and an upper surface of the waveguide 31 and connect to the insulating film 23b, thereby forming the insulating layer 23 that protects the waveguide 31 as illustrated in the second row in Fig. 9.

In a thirty-sixth step, as illustrated in the third row in Fig. 9, the color filter 24-1 and the color filter 24-2 are formed such that the waveguide 31 is provided therebetween. Thereafter, the on-chip lenses 25 are layered, and thus the imaging element 11B as illustrated in Fig. 7 is manufactured.

By the manufacturing method described above, it is possible to manufacture the imaging element 11B capable of suppressing the occurrence of color mixing between the pixels 12 and suppressing a decrease in the sensitivity of the pixels 12.

### First to Sixth Modification Examples of Imaging Element

First to sixth modification examples of the imaging element will be described with reference to Figs. 11 to 16.

Fig. 11 is a cross-sectional view illustrating a configuration example of an imaging element 11C according to a first modification example. In the imaging element 11C illustrated in Fig. 11, components common to those of the imaging element 11 in Fig. 1 are denoted by the same reference signs, and the detailed description thereof will be omitted.

As illustrated in Fig. 11, the semiconductor substrate 21, the high-dielectric-constant film 22, the insulating layer 23, the color filters 24, the on-chip lenses 25, and the waveguide 31 of the imaging element 11C are configured in the same manner as those of the imaging element 11 in Fig. 1. On the other hand, a metal layer 32C of the imaging element 11C has a configuration different from that of the metal layer 32 of the imaging element 11 in Fig. 1.

That is, in the imaging element 11C, the metal layer 32C is formed such that the width d2 of a metal layer 32C-2 is narrower than a trench formed in the semiconductor substrate 21, and the metal layer 32C-2 is formed deep enough to be inside the trench. That is, the metal layer 32C is formed such that a distal end of the metal layer 32C-2 enters the trench of the semiconductor substrate 21.

The imaging element 11C having such a configuration can suppress the occurrence of color mixing more than the imaging element 11B in Fig. 7 and can further improve image quality.

Fig. 12 is a cross-sectional view illustrating a configuration example of an imaging element 11D according to a second modification example. In the imaging element 11D illustrated in Fig. 12, components common to those of the imaging element 11 in Fig. 1 are denoted by the same reference signs, and detailed description thereof will be omitted.

As illustrated in Fig. 12, the semiconductor substrate 21, the high-dielectric-constant film 22, the insulating layer 23, the on-chip lenses 25, and the metal layer 32 of the imaging element 11D are configured in the same manner as those of the imaging element 11 in Fig. 1. On the other hand, color filters 24D and a waveguide 31D of the imaging element 11D have configurations different from those of the color filters 24 and the waveguide 31 of the imaging element 11 in Fig. 1.

That is, in the imaging element 11D, the height of the waveguide 31D is formed to be lower than that of the waveguide 31 in Fig. 1, and upper portions of a color filter 24D-1 and a color filter 24D-2 are formed in shapes protruding from both sides toward a space above the waveguide 31D. That is, the imaging element 11D is formed such that the waveguide 31D is shorter than the color filter 24D-1 and the color filter 24D-2.

In a manner similar to the imaging element 11 in Fig. 1, the imaging element 11D having such a configuration suppresses the occurrence of color mixing between the pixels 12 and suppresses a decrease in the sensitivity of the pixels 12, thereby enabling further improvement in image quality.

Fig. 13 is a cross-sectional view illustrating a configuration example of an imaging element 11E according to a third modification example. In the imaging element 11E illustrated in Fig. 13, components common to those of the imaging element 11 in Fig. 1 are denoted by the same reference signs, and detailed description thereof will be omitted.

As illustrated in Fig. 13, the semiconductor substrate 21, the high-dielectric-constant film 22, the insulating layer 23, the color filters 24, the on-chip lenses 25, and the waveguide 31 of the imaging element 11E are configured in the same manner as those of the imaging element 11 in Fig. 1. On the other hand, a metal layer 32E of the imaging element 11E has a configuration different from that of the metal layer 32 of the imaging element 11 in Fig. 1.

That is, in the imaging element 11E, the metal layer 32E is formed of a single type of metal such that an upper portion and a lower portion have different widths, and is configured in a shape curved so as to protrude downward. That is, by an upper surface being formed as a curved surface recessed downward, and a lower surface being formed as a curved surface convex downward, the metal layer 32E assumes a curved shape on the whole. Both side surfaces of the metal layer 32E are also formed as curved surfaces, recessed inward.

As illustrated in B in Fig. 13, the metal layer 32E having such a curved shape is configured in a shape with the width d1 in the upper portion of the metal layer 32E being equal to or less than a width E of the waveguide 31, and is configured in a shape with the width d2 in the lower portion of the metal layer 32E being narrower than the width d1 in the upper portion of the metal layer 32E.

In a manner similar to the imaging element 11 in Fig. 1, the imaging element 11E having such a configuration suppresses the occurrence of color mixing between the pixels 12 and suppresses a decrease in the sensitivity of the pixels 12, thereby enabling further improvement in image quality.

Fig. 14 is a cross-sectional view illustrating a configuration example of an imaging element 11F according to a fourth modification example. In the imaging element 11F illustrated in Fig. 14, components common to those of the imaging element 11 in Fig. 1 are denoted by the same reference signs, and detailed description thereof will be omitted.

As illustrated in Fig. 14, the semiconductor substrate 21, the high-dielectric-constant film 22, the insulating layer 23, the color filters 24, the on-chip lenses 25, and the waveguide 31 of the imaging element 11F are configured in the same manner as those of the imaging element 11 in Fig. 1. On the other hand, a metal layer 32F of the imaging element 11F has a configuration different from that of the metal layer 32 of the imaging element 11 in Fig. 1.

That is, the metal layer 32 in Fig. 1 is formed such that the width d1 of the metal layer 32-1 is equal to or less than the width D of the waveguide 31, whereas the metal layer 32F is configured in a shape in which the width d1 of a metal layer 32F-1 is narrower than the width D of the waveguide 31 as illustrated in B in Fig. 13. In addition, the width d2 of a metal layer 32F-2 is formed to be narrower than the width d1 of the metal layer 32F-1.

In a manner similar to the imaging element 11 in Fig. 1, the imaging element 11F having such a configuration suppresses the occurrence of color mixing between the pixels 12 and suppresses a decrease in the sensitivity of the pixels 12, thereby enabling further improvement in image quality.

Fig. 15 is a cross-sectional view illustrating a configuration example of an imaging element 11G according to a fifth modification example. In the imaging element 11G illustrated in Fig. 15, components common to those of the imaging element 11 in Fig. 1 are denoted by the same reference signs, and detailed description thereof will be omitted.

As illustrated in Fig. 15, the semiconductor substrate 21, the high-dielectric-constant film 22, the insulating layer 23, the color filters 24, the on-chip lenses 25, and the metal layer 32 of the imaging element 11G are configured in the same manner as those of the imaging element 11 in Fig. 1. On the other hand, a waveguide 31G of the imaging element 11G has a configuration different from that of the waveguide 31 of the imaging element 11 in Fig. 1.

For example, the imaging element 11G is configured such that the waveguide 31G is hollow, and air is used as the low-refractive-index material of the waveguide 31G.

In a manner similar to the imaging element 11 in Fig. 1, the imaging element 11G having such a configuration suppresses the occurrence of color mixing between the pixels 12 and suppresses a decrease in the sensitivity of the pixels 12, thereby enabling further improvement in image quality.

Fig. 16 is a cross-sectional view illustrating a configuration example of an imaging element 11H according to a sixth modification example. In the imaging element 11H illustrated in Fig. 16, components common to those of the imaging element 11 in Fig. 1 are denoted by the same reference signs, and detailed description thereof will be omitted.

As illustrated in Fig. 16, the semiconductor substrate 21, the high-dielectric-constant film 22, the insulating layer 23, the color filters 24, the on-chip lenses 25, and the metal layer 32 of the imaging element 11H are configured in the same manner as those of the imaging element 11 in Fig. 1. On the other hand, a waveguide 31H of the imaging element 11H has a configuration different from that of the waveguide 31 of the imaging element 11 in Fig. 1.

For example, the imaging element 11H is configured such that the waveguide 31H is hollow, an upper surface of the waveguide 31H is formed to be recessed in a V shape, and air is used as the low-refractive-index material of the waveguide 31H. Note that the upper surface of the waveguide 31H may be formed so as to be recessed in any shape other than the V-shape.

In a manner similar to the imaging element 11 in Fig. 1, the imaging element 11H having such a configuration suppresses the occurrence of color mixing between the pixels 12 and suppresses a decrease in the sensitivity of the pixels 12, thereby enabling further improvement in image quality.

### Configuration Example of Electronic Apparatus

The imaging element 11 as described above can be applied to various electronic apparatuses such as, for example, an imaging system such as a digital still camera or a digital video camera, a mobile telephone having an imaging function, and other apparatuses having an imaging function.

Fig. 17 is a block diagram illustrating a configuration example of an imaging device mounted in an electronic apparatus.

As illustrated in Fig. 17, an imaging device 101 includes an optical system 102, an imaging element 103, a signal processing circuit 104, a monitor 105, and a memory 106, and can capture a still image and a moving image.

The optical system 102 includes one or more lenses, guides image light (incident light) from a subject to the imaging element 103, and forms an image on a light receiving surface (sensor unit) of the imaging element 103.

As the imaging element 103, the imaging element 11 described above is applied. Electrons are accumulated in the imaging element 103 for a certain period of time according to the image formed on the light receiving surface via the optical system 102. Then, signals corresponding to the electrons accumulated in the imaging element 103 are supplied to the signal processing circuit 104.

The signal processing circuit 104 performs various types of signal processing on the pixel signals output from the imaging element 103. An image (image data) obtained by the signal processing circuit 104 performing the signal processing is supplied to and displayed on the monitor 105 or supplied to and stored (recorded) in the memory 106.

By applying the imaging element 11 described above, the imaging device 101 configured in this manner can, for example, capture an image with higher image quality.

### Usage Examples of Image Sensor

Fig. 18 is a diagram illustrating usage examples of using the above-described image sensor (imaging element).

The image sensor described above can be used in various cases of sensing light such as visible light, infrared light, ultraviolet light, and X-rays, as follows, for example.
- Devices for capturing an image used for viewing purposes, such as a digital camera and a mobile device having a camera function
- Devices used for traffic purposes, such as an in-vehicle sensor that captures images ahead of or behind an automobile, of the surroundings, of the vehicle interior, and the like for purposes such as safe driving, including automatically stopping, and driver state recognition; a monitoring camera that monitors traveling vehicles and roads; and a distance measurement sensor that measures the distance between vehicles and the like
- Devices used for household appliances such as a TV, a refrigerator, and an air conditioner to capture a gesture of a user and operate the appliance according to the gesture
- Devices used for medical care and healthcare purposes, such as an endoscope and a device for performing angiography by receiving infrared light
- Devices used for security purposes, such as a surveillance camera for crime prevention and a camera for person authentication
- Devices used for beauty care purposes, such as a skin measuring instrument that captures an image of the skin and a microscope that captures an image of the scalp
- Devices used for sports purposes, such as an action camera and a wearable camera intended for sports applications or the like
- Devices used for agricultural purposes, such as a camera for monitoring the condition of a field or crops

### Examples of Combinations of Configurations

Note that the present technology can also have the following configurations.
(1) A solid-state imaging element including
   a color filter provided, for each of a plurality of pixels, on a back surface side of a semiconductor substrate with an insulating layer interposed between the color filter and the semiconductor substrate, the back surface side of the semiconductor substrate being illuminated with light,
   a waveguide disposed between adjacent ones of the color filters, the waveguide being formed of a low-refractive-index material having a refractive index lower than a refractive index of the color filters, and
   a metal layer disposed on a semiconductor substrate side of the waveguide and in the insulating layer on the semiconductor substrate side of a semiconductor-substrate-side surface of the color filters, the metal layer being configured in a shape in which a width of a lower portion closer to the semiconductor substrate is narrower than a width of an upper portion closer to the waveguide.
(2) The solid-state imaging element according to (1) described above, wherein
   the metal layer is configured such that the width of the upper portion is equal to or less than a width of the waveguide.
(3) The solid-state imaging element according to (1) or (2) described above, wherein
   the metal layer has a two-layer structure in which the upper portion and the lower portion are formed of different types of metals.
(4) The solid-state imaging element according to (1) or (2) described above, wherein
   the metal layer has a single-layer structure in which the upper portion and the lower portion are formed of the same type of metal.
(5) The solid-state imaging element according to any of (1) to (4) described above, wherein
   the metal layer has a two-layer structure of a first metal layer and a second metal layer, the first metal layer having a width equal to or less than a width of the waveguide, the second metal layer having a width narrower than the width of the first metal layer, and
   the second metal layer is formed to a depth in a vicinity of the semiconductor substrate.
(6) The solid-state imaging element according to any of (1) to (5) described above, wherein
   the metal layer has a two-layer structure of a first metal layer and a second metal layer, the first metal layer having a width equal to or less than a width of the waveguide, the second metal layer having a width narrower than the width of the first metal layer, and
   the metal layer is formed such that the width of the second metal layer is narrower than a width of a trench provided between the pixels of the semiconductor substrate and a distal end of the second metal layer is deep enough to enter the trench.
(7) The solid-state imaging element according to any of (1) to (6) described above, wherein
   a height of the waveguide is lower than a height of the color filter.
(8) The solid-state imaging element according to any of (1) to (7) described above, wherein
   the metal layer is configured in a curved shape protruding toward the semiconductor substrate.
(9) The solid-state imaging element according to any of (3) to (8) described above, wherein
   the metal layer is configured in a shape in which the width of the upper portion is narrower than a width of the waveguide.
(10) The solid-state imaging element according to any of (1) to (9) described above, wherein
   the waveguide is configured such that air is used as the low-refractive-index material.
(11) The solid-state imaging element according to (10) described above, wherein
   an upper surface of the waveguide is formed in a recessed shape.
(12) The solid-state imaging element according to any of (1) to (11) described above, wherein
   a trench separating the pixels from each other is formed in the semiconductor substrate, and an insulator is embedded in the trench.
(13) The solid-state imaging element according to (12) described above, wherein
   the trench is formed by digging from the back surface side or a front surface side of the semiconductor substrate.
(14) A method of manufacturing a solid-state imaging element, the method including
   providing, for each of a plurality of pixels, a color filter on a back surface side of a semiconductor substrate with an insulating layer interposed between the color filter and the semiconductor substrate, the back surface side of the semiconductor substrate being illuminated with light,
   providing a waveguide disposed between adjacent ones of the color filters, the waveguide being formed of a low-refractive-index material having a refractive index lower than a refractive index of the color filters, and
   providing a metal layer disposed on a semiconductor substrate side of the waveguide and in the insulating layer on the semiconductor substrate side of a semiconductor-substrate-side surface of the color filters, the metal layer being configured in a shape in which a width of a lower portion closer to the semiconductor substrate is narrower than a width of an upper portion closer to the waveguide.
(15) An electronic apparatus including a solid-state imaging element including
   a color filter provided, for each of a plurality of pixels, on a back surface side of a semiconductor substrate with an insulating layer interposed between the color filter and the semiconductor substrate, the back surface side of the semiconductor substrate being illuminated with light,
   a waveguide disposed between adjacent ones of the color filters, the waveguide being formed of a low-refractive-index material having a refractive index lower than a refractive index of the color filters, and
   a metal layer disposed on a semiconductor substrate side of the waveguide and in the insulating layer on the semiconductor substrate side of a semiconductor-substrate-side surface of the color filters, the metal layer being configured in a shape in which a width of a lower portion closer to the semiconductor substrate is narrower than a width of an upper portion closer to the waveguide.

Note that the present embodiment is not limited to the embodiments described above, and various modifications can be made without departing from the gist of the present disclosure. In addition, the effects described in the present specification are mere examples, and are not limiting. There may be other effects.

### Reference Signs List

11 Imaging element, 12 Pixel, 21 Semiconductor substrate, 22 High-dielectric-constant film, 23 Insulating layer, 24 Color filter, 25 On-chip lens, 31 Waveguide, 32 Metal layer, 41 Metal film, 42 Waveguide member, 43 Groove Portion.

## Claims

1. A solid-state imaging element comprising:
a color filter provided, for each of a plurality of pixels, on a back surface side of a semiconductor substrate with an insulating layer interposed between the color filter and the semiconductor substrate, the back surface side of the semiconductor substrate being illuminated with light;
a waveguide disposed between adjacent ones of the color filters, the waveguide being formed of a low-refractive-index material having a refractive index lower than a refractive index of the color filters; and
a metal layer disposed on a semiconductor substrate side of the waveguide and in the insulating layer on the semiconductor substrate side of a semiconductor-substrate-side surface of the color filters, the metal layer being configured in a shape in which a width of a lower portion closer to the semiconductor substrate is narrower than a width of an upper portion closer to the waveguide.

2. The solid-state imaging element according to claim 1, wherein
the metal layer is configured such that the width of the upper portion is equal to or less than a width of the waveguide.

3. The solid-state imaging element according to claim 1, wherein
the metal layer has a two-layer structure in which the upper portion and the lower portion are formed of different types of metals.

4. The solid-state imaging element according to claim 1, wherein
the metal layer has a single-layer structure in which the upper portion and the lower portion are formed of the same type of metal.

5. The solid-state imaging element according to claim 1, wherein
the metal layer has a two-layer structure of a first metal layer and a second metal layer, the first metal layer having a width equal to or less than a width of the waveguide, the second metal layer having a width narrower than the width of the first metal layer, and
the second metal layer is formed to a depth in a vicinity of the semiconductor substrate.

6. The solid-state imaging element according to claim 1, wherein
the metal layer has a two-layer structure of a first metal layer and a second metal layer, the first metal layer having a width equal to or less than a width of the waveguide, the second metal layer having a width narrower than the width of the first metal layer, and
the metal layer is formed such that the width of the second metal layer is narrower than a width of a trench provided between the pixels of the semiconductor substrate and a distal end of the second metal layer is deep enough to enter the trench.

7. The solid-state imaging element according to claim 1, wherein
a height of the waveguide is lower than a height of the color filter.

8. The solid-state imaging element according to claim 1, wherein
the metal layer is configured in a curved shape protruding toward the semiconductor substrate.

9. The solid-state imaging element according to claim 1, wherein
the metal layer is configured in a shape in which the width of the upper portion is narrower than a width of the waveguide.

10. The solid-state imaging element according to claim 1, wherein
the waveguide is configured such that air is used as the low-refractive-index material.

11. The solid-state imaging element according to claim 10, wherein an upper surface of the waveguide is formed in a recessed shape.

12. The solid-state imaging element according to claim 1, wherein
a trench separating the pixels from each other is formed in the semiconductor substrate, and an insulator is embedded in the trench.

13. The solid-state imaging element according to claim 12, wherein
the trench is formed by digging from the back surface side or a front surface side of the semiconductor substrate.

14. A method of manufacturing a solid-state imaging element, the method comprising:
providing, for each of a plurality of pixels, a color filter on a back surface side of a semiconductor substrate with an insulating layer interposed between the color filter and the semiconductor substrate, the back surface side of the semiconductor substrate being illuminated with light;
providing a waveguide disposed between adjacent ones of the color filters, the waveguide being formed of a low-refractive-index material having a refractive index lower than a refractive index of the color filters; and
providing a metal layer disposed on a semiconductor substrate side of the waveguide and in the insulating layer on the semiconductor substrate side of a semiconductor-substrate-side surface of the color filters, the metal layer being configured in a shape in which a width of a lower portion closer to the semiconductor substrate is narrower than a width of an upper portion closer to the waveguide.

15. An electronic apparatus comprising:
a solid-state imaging element including
a color filter provided, for each of a plurality of pixels, on a back surface side of a semiconductor substrate with an insulating layer interposed between the color filter and the semiconductor substrate, the back surface side of the semiconductor substrate being illuminated with light;
a waveguide disposed between adjacent ones of the color filters, the waveguide being formed of a low-refractive-index material having a refractive index lower than a refractive index of the color filters; and
a metal layer disposed on a semiconductor substrate side of the waveguide and in the insulating layer on the semiconductor substrate side of a semiconductor-substrate-side surface of the color filters, the metal layer being configured in a shape in which a width of a lower portion closer to the semiconductor substrate is narrower than a width of an upper portion closer to the waveguide.
